# FASCICULE DE BREVET EUROPEEN

(11) **EP 3 184 486 B1**
(45) Date de publication et mention de la délivrance du brevet: **07.03.2018**
(21) Numéro de dépôt: 16206514.8
(22) Date de dépôt: 22.12.2016
(51) Int. Cl.: B81C 1/00

(54) **PROCÉDÉ DE RÉALISATION D'UNE CAVITÉ FERMÉE COMPORTANT UN CLAPET PROTÉGEANT LA CAVITÉ LORS DE SA FERMETURE**
VERFAHREN ZUR HERSTELLUNG EINES VERSIEGELTEN MEMS-HOHLRAUMS MIT EINER KLAPPE ZUM SCHÜTZEN DES HOHLRAUMS WÄHREND DES VERKAPSELUNGSVORGANGS
PROCESS FOR MANUFACTURING A SEALED MEMS PACKAGE CAVITY WITH FLAP PROTECTING THE CAVITY DURING THE SEALING PROCESS

(30) Priorité: 23.12.2015 FR 1563190
(43) Date de publication de la demande: 28.06.2017
(73) Titulaire: COMMISSARIAT À L'ÉNERGIE ATOMIQUE ET AUX ÉNERGIES ALTERNATIVES, 75015 Paris (FR)
(72) Inventeur: REIG, Bruno, 38430 Moirans (FR); SAINT-PATRICE, Damien, 26120 Chabeuil (FR)
(74) Mandataire: Brevalex

(56) Documents cités:
- WO-A1-2011/003908
- FR-A1- 2 864 340
- FR-A1- 2 948 928
- US-A1- 2011 053 321

## Description

### DOMAINE TECHNIQUE ET ART ANTÉRIEUR

L'invention se rapporte au domaine de la microélectronique, et plus particulièrement à celui de la réalisation de cavités fermées servant notamment à l'encapsulation de dispositifs microélectroniques par exemple de type MEMS (microsystèmes électromécaniques) et/ou NEMS (nanosystèmes électromécaniques) et/ou MOEMS (microsystèmes opto-électromécaniques) et/ou NOEMS (nanosystèmes opto-électromécaniques).

L'invention concerne notamment un procédé d'encapsulation de type Packaging Couche Mince (PCM), ou « Thin-Film Packaging » ou TFP en anglais. Une telle encapsulation est avantageusement mise en oeuvre de manière collective pour plusieurs dispositifs microélectroniques réalisés sur un même substrat, réalisant alors un packaging à l'échelle du substrat, ou WLP pour « Wafer Level Packaging ».

De nombreux dispositifs microélectroniques nécessitent un packaging pour assurer leur fonctionnalité. Ce packaging a d'une part un rôle de protection contre certaines perturbations de l'environnement extérieur (poussière, humidité, variation de pression, influence des gaz ...), et est d'autre part utilisé pour assurer la fonctionnalité du dispositif. C'est par exemple le cas des microsystèmes MEMS ou NEMS dont le fonctionnement des parties mobiles peut nécessiter un contrôle de l'atmosphère et/ou de la pression (atmosphère de N₂ pour des micro-commutateurs MEMS, environnement sous vide pour des résonateurs MEMS, etc.).

Dans un contexte de miniaturisation et de réduction du coût des dispositifs, un procédé d'encapsulation de type packaging couche mince a été développé. Ce procédé consiste à déposer une couche de matériau sacrificiel (par exemple du silicium ou de la résine organique) localisée au-dessus du dispositif à protéger. Le matériau formant le capot (par exemple une couche minérale telle que du SiO₂) est ensuite déposé sur cette couche sacrificielle et des trous sont réalisés dans cette couche, par exemple via une étape de gravure sèche. Le matériau sacrificiel est ensuite éliminé à travers ces trous, généralement par une étape de gravure sèche isotrope, afin de libérer le capot et former une cavité dans laquelle le dispositif est encapsulé. Les trous sont ensuite bouchés afin de rendre la cavité étanche ou hermétique.

L'étape de bouchage est généralement réalisée soit par dépôt (de type PVD ou dépôt physique en phase vapeur, PECVD ou dépôt chimique en phase vapeur assisté par plasma, etc.) de couche métalliques ou minérales, soit par « spin coating », ou enduction centrifuge, de polymère. La difficulté de mise en oeuvre de ce bouchage consiste à ne pas déposer de matériau de bouchage à l'intérieur de la cavité, ce qui pourrait nuire au bon fonctionnement du dispositif microélectronique encapsulé.

Le diamètre et le nombre de trous de libération sont donc définis de façon à trouver un compromis entre un temps de libération court, obtenu en réalisant les trous de libération avec le plus grand diamètre possible, et la facilité de bouchage, obtenue en réalisant les trous de libération avec le plus petit diamètre possible.

Afin de s'affranchir de ce compromis et éviter le dépôt de matériau de bouchage dans la cavité, plusieurs solutions ont été proposées.

Afin de limiter le dépôt résiduel de matériau de bouchage dans la cavité, le document US 2012/0161255 A1 propose de déposer par CVD une première couche de pré-bouchage dans les trous de libération, ce qui permet de réduire la taille des trous, puis de réaliser un deuxième dépôt CVD du matériau de bouchage qui permet d'obtenir le bouchage final des trous dans les conditions d'atmosphère souhaitées. Cette méthode ne permet toutefois pas d'éviter complètement les dépôts résiduels dans la cavité des matériaux de pré-bouchage et de bouchage. De plus, le diamètre des trous est limité au plus à quelques microns afin de pouvoir les boucher en tentant d'éviter les dépôts résiduels dans la cavité.

Dans le document US 2004/0166606 A1, le dépôt résiduel du matériau de bouchage dans la cavité est évité en choisissant un matériau de bouchage ayant une viscosité suffisante pour ne pas fluer dans la cavité lors de l'étape de bouchage. Dans ce cas, la gamme des matériaux de bouchage pouvant être utilisés est limitée à un matériau suffisamment visqueux. De plus, le diamètre des trous est également limité au plus à quelques microns afin de pouvoir les boucher sans dépôts résiduels dans la cavité.

Pour éviter les dépôts résiduels du matériau de bouchage dans la cavité, le document US 2011/0053321 A1 propose de déposer le matériau de bouchage en mettant un angle entre la plaque traversée par les trous à boucher et la direction de dépôt du matériau de bouchage dans la chambre de dépôt. Le matériau de bouchage n'est ainsi pas déposé perpendiculairement au trou et le dépôt du matériau de bouchage à l'intérieur de la cavité est limité. Toutefois, l'inconvénient de cette méthode est la nécessité d'avoir une chambre de dépôt spécifique permettant le dépôt avec un angle particulier par rapport au capot.

Dans le document WO 2006/081636 A1, le capot est formé par une couche poreuse. Les pores de cette couche sont utilisés comme des trous de libération pour éliminer la couche sacrificielle. Ces pores sont très fins (avec des rapports hauteur/diamètre supérieurs à 10 et des diamètres inférieurs au micron) de sorte que le matériau de bouchage ne peut pas passer à travers ces trous pour se déposer dans la cavité. L'inconvénient de cette technique est la difficulté technologique de réaliser un capot en matériau poreux, avec de plus un choix limité de matériau pour réaliser ce capot.

Dans le document WO 2011/003908 A1, les trous de libération sont formés en périphérie du capot. Si le bouchage mis en oeuvre laisse des dépôts résiduels à l'intérieur de la cavité, ces dépôts sont localisés en périphérie de cette cavité, dans des zones où ce dépôt résiduel ne perturbe pas le dispositif encapsulé. L'inconvénient de cette méthode toutefois est que le temps de libération de la totalité de la cavité à partir d'un trou situé en périphérie est très long.

Dans le document US 2008/0079142 A1, un capot est formé en deux couches espacées l'une de l'autre et percées chacune de trous de libération. Les trous réalisés dans chacune de ces couches ne se superposent pas, formant ainsi un réseau de chicanes pour accéder dans la cavité depuis l'extérieur. La couche la plus proche du dispositif encapsulé sert alors de couche protectrice par rapport au matériau de bouchage, les dépôts résiduels se faisant sur cette couche protectrice et pas sur le dispositif se trouvant à l'intérieur de la cavité. Le principal inconvénient de cette technique est l'ajout de nombreuses étapes technologiques supplémentaires pour former la deuxième couche de capot (couche sacrificielle additionnelle, deuxième couche de capot avec trous de libération, libération entre les deux capots) qui ont une répercussion importante sur le coût final du dispositif.

Dans le document FR 2 948 928 A1, un système faisant office de clapet est réalisé. Ce clapet est en position ouverte pour l'étape de libération puis amené en position fermée sous le trou de libération pendant l'étape de bouchage. Le trou de libération peut ainsi être large, le matériau de bouchage se déposant à l'intérieur du trou en prenant appui sur le clapet. Le document FR 2 864 340 A1 décrit également un système avec un clapet situé au-dessus du capot. Dans ces deux documents, le clapet est réalisé sur une couche sacrificielle additionnelle et ces procédés nécessitent donc la mise en oeuvre d'étapes technologiques supplémentaires pour déposer et localiser cette couche sacrificielle, puis pour éliminer cette couche sacrificielle additionnelle.

### EXPOSÉ DE L'INVENTION

Un but de la présente invention est de proposer un procédé de réalisation d'une cavité fermée pouvant servir à l'encapsulation d'un ou plusieurs dispositifs microélectroniques et ne présentant pas les inconvénients des procédés d'encapsulation de l'art antérieur précédemment décrits, c'est-à-dire permettant :
- de s'affranchir du compromis relatif aux dimensions du ou des trous de libération ;
- d'éviter le dépôt du matériau de bouchage dans la cavité ;
- de ne pas limiter le procédé à certains types de matériau de bouchage ;
- d'éviter l'utilisation d'une chambre de dépôt spécifique permettant le dépôt du matériau de bouchage avec un angle particulier par rapport au capot ;
- d'éviter la réalisation d'un capot en matériau poreux ;
- de graver rapidement la portion sacrificielle servant à former la cavité ;
- de limiter le nombre d'étapes additionnelles par rapport à une procédé d'encapsulation PCM classique ;
- d'éviter l'utilisation d'une couche sacrificielle supplémentaire par rapport à un procédé d'encapsulation PCM classique.

Pour cela, la présente invention propose un procédé de réalisation d'au moins une cavité fermée, comportant au moins les étapes suivantes :
- réalisation d'une portion sacrificielle sur un substrat ;
- réalisation d'un capot recouvrant la portion sacrificielle ;
- réalisation d'au moins un trou à travers le capot ;
- réalisation, sur le capot, d'une première couche telle que, selon une première configuration, la première couche recouvre au moins une première région du capot localisée autour du trou, ou selon une deuxième configuration, la première couche entoure la première région du capot ;
- dépôt d'au moins une deuxième couche recouvrant le capot et la première couche et telle que, selon la première configuration, une force d'adhérence entre les première et deuxième couches est inférieure à une force d'adhérence entre la deuxième couche et une deuxième région du capot juxtaposée à la première région du capot ou, selon la deuxième configuration, une force d'adhérence entre la deuxième couche et la première région du capot est inférieure à une force d'adhérence entre les première et deuxième couches ;
- gravure de la deuxième couche telle qu'une portion restante de la deuxième couche forme au moins un clapet dont une première partie localisée en regard du trou et de la première région du capot ne ferme pas le trou hermétiquement ou de manière étanche, et dont une deuxième partie est solidaire de la deuxième région du capot ;
- gravure de la portion sacrificielle à travers le trou, formant la cavité entre le capot et le substrat ;
- fermeture de la cavité par un dépôt d'un matériau de bouchage au moins sur la première partie du clapet et au moins une partie du capot autour de la première région du capot.

Ce procédé fait donc appel à une première couche ayant des caractéristiques d'adhérence différentes de celles du capot. Ainsi, le clapet, qui comporte un première partie localisée au niveau de la première région du capot et une deuxième partie localisée au niveau d'une deuxième région du capot, est réalisé sur deux zones ayant des adhérences différentes et telles que seulement la deuxième partie du clapet soit ancrée au capot, soit directement à celui-ci dans le cas de la première configuration où la première couche recouvre la première région du capot, soit par l'intermédiaire de la première couche dans le cas de la deuxième configuration où la première couche entoure la première région du capot et recouvre la deuxième région du capot.

Dans la première configuration, la première couche recouvre la première région du capot et forme la zone au niveau de laquelle le clapet (sa première partie) n'est pas destiné à être solidarisé fermement, ou ancré, au capot. Dans la deuxième configuration, la première couche est formée autour de cette première région du capot qui forme directement la zone au niveau de laquelle le clapet (sa première partie) n'est pas destiné à être solidarisé fermement, ou ancré, au capot.

Cette absence d'adhérence, ou cette faible adhérence, entre la première partie du clapet et la première couche (dans le cas de la première configuration) ou la première région du capot (dans le cas de la deuxième configuration) permet au clapet de ne pas fermer le trou hermétiquement ou de manière étanche, et donc de graver la portion sacrificielle à travers le trou, et cela même si la première partie du clapet est disposé sur, ou recouvre, le trou.

Ce procédé permet d'éviter le dépôt de matériau de bouchage dans la cavité du fait que le clapet est présent au-dessus du trou lors du dépôt du matériau de bouchage. De plus, cela autorise de réaliser un ou plusieurs trous de dimensions importantes (diamètre pouvant être égal à quelques dizaines de microns voire même supérieur à environ 100 microns) sans risquer le dépôt de matériau de bouchage dans la cavité.

Ce procédé est en outre compatible avec tout type de matériau de bouchage, ne nécessite pas la mise en oeuvre du dépôt du matériau de bouchage dans une chambre de dépôt particulière, ne nécessite pas la réalisation d'un capot en matériau poreux, permet de localiser n'importe où le ou les trous sur le capot, et ne nécessite pas la réalisation d'une couche sacrificielle additionnelle servant à la réalisation du clapet.

Selon la première configuration, le clapet peut adhérer à la deuxième région du capot et peut ne pas adhérer à la première couche ou, selon la deuxième configuration, le clapet peut adhérer à la première couche et peut ne pas adhérer à la première région du capot. L'expression « ne pas adhérer » doit être comprise comme signifiant que le clapet n'est pas solidement ancré, ou solidarisé, à la première couche (cas de la première configuration) ou à la première région du capot (cas de la deuxième configuration). Cette expression peut signifier que la première partie du clapet forme une partie libre non solidaire de la première couche (première configuration) ou de la première région du capot (deuxième configuration).

Selon la première configuration, la force d'adhérence entre les première et deuxième couches peut être inférieure à environ 2 N/mm² ou, selon la deuxième configuration, la force d'adhérence entre la deuxième couche et la première région du capot peut être inférieure à environ 2 N/mm².

Selon la première configuration, une partie de la première couche peut être disposée dans le trou, et la gravure de la portion sacrificielle peut être précédée d'une gravure d'au moins la partie de la première couche disposée dans le trou.

Selon la première configuration, une force d'adhérence entre la deuxième couche et la deuxième région du capot peut être supérieure ou égale à environ 20 N/mm² ou, selon la deuxième configuration, une force d'adhérence entre les première et deuxième couches peut être supérieure ou égale à environ 20 N/mm². Une telle force d'adhérence permet d'obtenir un bon ancrage de la deuxième partie du clapet avec le capot (directement ou par l'intermédiaire de la première couche selon la configuration envisagée).

Selon la première configuration, la première couche peut comporter au moins un polymère, ou, selon la deuxième configuration, la première couche peut comporter au moins un métal.

Selon un premier exemple de réalisation de la première configuration, le capot peut comporter du SiO₂ et/ou du SiN et/ou au moins un métal tel que de l'Al, de l'Au, etc., la première couche peut comporter un polymère tel que du PTFE, et la deuxième couche peut comporter du SiO₂ et/ou du SiN et/ou au moins un métal ou un empilement de plusieurs métaux tels que de l'Au, du Ti, de l'Al, du Ni, de l'AlSi, de l'AlCu, etc. Selon un deuxième exemple de réalisation de la première configuration, le capot peut comporter du SiO₂ et/ou du SiN, la première couche peut comporter du Ru et/ou du Ti+Au et/ou du W+Au, et la deuxième couche peut comporter du SiO₂ déposé avec un gaz précurseur de TEOS et/ou du SiN.

Selon un premier exemple de réalisation de la deuxième configuration, le capot peut comporter du SiO₂ et/ou du SiN, la première couche peut comporter au moins un métal ou un empilement de plusieurs métaux tels que du Ti et/ou du W et/ou du TiN, et la deuxième couche peut comporter de l'Au et/ou du Cu et/ou du Pt et/ou du Ni. Selon un deuxième exemple de réalisation de la deuxième configuration, le capot peut comporter de l'Au, la première couche peut comporter du SiO₂ déposé avec un gaz précurseur de SiH₄, et la deuxième couche peut comporter du SiO₂ déposé avec un gaz précurseur de TEOS.

La deuxième couche peut avoir une contrainte résiduelle engendrant, après la gravure de la deuxième couche, une déformation de la première partie du clapet espaçant la première partie du clapet vis-à-vis de la première région du capot et telle que la première partie du clapet reste disposée en regard du trou. Un tel espacement est très avantageux car il permet d'accélérer la gravure de la portion sacrificielle sans compromettre la protection conférée par le clapet car la première partie du clapet reste en regard du trou lors du dépôt du matériau de bouchage.

Il est également possible que la deuxième couche comporte au moins des premier et deuxième matériaux distincts, superposés tels que le premier matériau soit disposé entre le deuxième matériau et le capot, et ayant des contraintes résiduelles de valeurs et/ou de types différents engendrant, après la gravure de la deuxième couche, une déformation de la première partie du clapet espaçant la première partie du clapet vis-à-vis de la première région du capot. Là encore, un tel espacement est très avantageux car il permet d'accélérer la gravure de la portion sacrificielle.

Le procédé peut comporter en outre, entre la gravure de la portion sacrificielle et la fermeture de la cavité, une étape de gravure d'au moins une partie du deuxième matériau. Cette gravure d'au moins une partie du deuxième matériau permet de faire revenir le clapet à sa position initiale, ou une position proche de sa position initiale, une fois la gravure de la portion sacrificielle terminée, avant de réaliser le dépôt du matériau de bouchage.

Dans ce cas, le premier matériau et/ou le deuxième matériau peut comporter une contrainte résiduelle.

La contrainte résiduelle peut être une contrainte en compression ou en tension. Les premier et deuxième matériaux peuvent ou non avoir une contrainte du même type (compression ou tension). La contrainte résiduelle du deuxième matériau peut être supérieure à celle du premier matériau pour que le clapet puisse se soulever. Par exemple, le deuxième matériau peut avoir une contrainte en tension supérieure à la contrainte du premier matériau ou une contrainte en compression moindre que celle du premier matériau.

Selon un exemple de réalisation, le premier matériau peut comporter du SiO₂ et le deuxième matériau peut comporter du nickel.

Le deuxième matériau peut comporter un empilement de titane et de nickel tel que le titane soit disposé entre le premier matériau et le nickel.

Que la deuxième couche soit réalisée ou non avec un ou plusieurs matériaux ayant des contraintes résiduelles, la deuxième couche peut comporter au moins des premier et deuxième matériaux distincts et superposés tels que le premier matériau soit disposé entre le deuxième matériau et le capot, le premier matériau pouvant avoir un coefficient de dilatation thermique supérieur à celui du deuxième matériau, et la gravure de la portion sacrificielle peut être mise en oeuvre à une température engendrant une déformation de la première partie du clapet due à la dilatation thermique des premier et deuxième matériaux, espaçant la première partie du clapet vis-à-vis de la première région du capot.

Dans ce cas, le premier matériau peut comporter de l'aluminium et le deuxième matériau peut comporter du titane.

De plus, le dépôt du matériau de bouchage peut avantageusement être mis en oeuvre à température ambiante, ce qui permet au clapet de retrouver sa position initiale lors du dépôt du matériau de bouchage.

La deuxième couche peut comporter au moins un matériau getter.

Plusieurs trous peuvent être réalisés à travers le capot et :
- la première partie du clapet peut être localisée en regard d'au moins deux desdits trous, et/ou
- la gravure de la deuxième couche peut former plusieurs clapets tels que la première partie de chacun des clapets soit disposée en regard d'au moins un desdits trous.

La portion sacrificielle peut être réalisée sur le substrat telle qu'elle recouvre au moins un dispositif microélectronique disposé sur le substrat, le dispositif microélectronique pouvant être encapsulé dans la cavité fermée à l'issu du procédé.

De plus, les étapes mises en oeuvre peuvent réaliser une encapsulation collective de plusieurs dispositifs microélectroniques disposés sur le substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 7 représentent les étapes d'un procédé de réalisation d'une cavité fermée, objet de la présente invention, selon un premier mode de réalisation ;
- la figure 8 représente différents exemples de réalisation du clapet formé lors de la mise en oeuvre du procédé de réalisation de la cavité fermée, objet de la présente invention ;
- les figures 9 et 10 représentent des étapes du procédé de réalisation de la cavité fermée, objet de la présente invention, selon une variante du premier mode de réalisation ;
- la figure 11 représente différents exemple de réalisation de clapets formés lors de la mise en oeuvre du procédé de réalisation de la cavité fermée, objet de la présente invention ;
- les figures 12 à 18 représentent les étapes d'un procédé de réalisation d'une cavité fermée, objet de la présente invention, selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

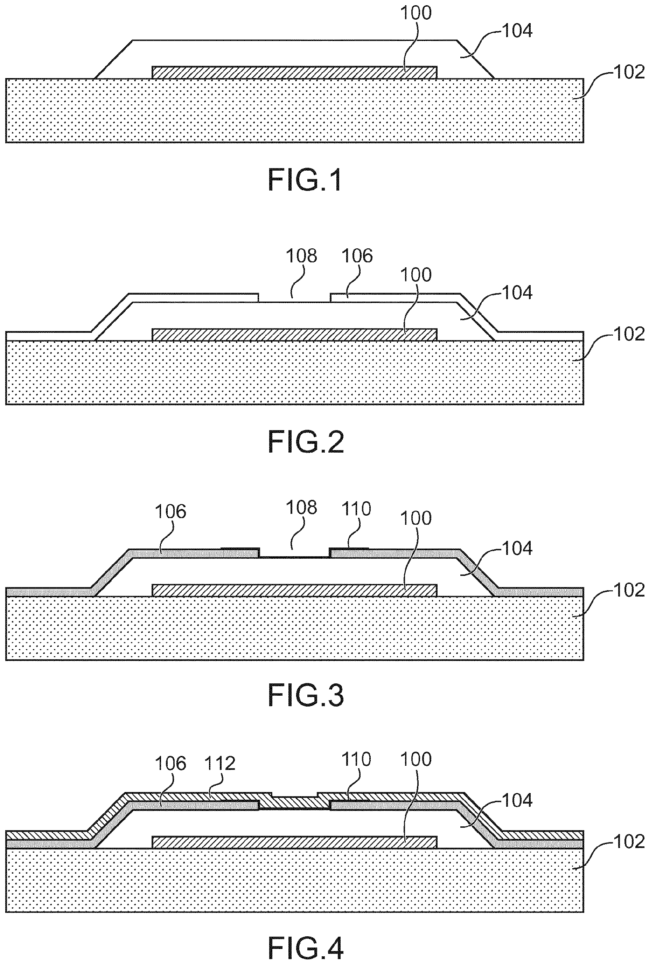

On se réfère tout d'abord aux figures 1 à 7 qui représentent les étapes d'un procédé de réalisation d'une cavité fermée 122 servant à l'encapsulation d'un dispositif microélectronique 100 selon un premier mode de réalisation.

Le dispositif microélectronique 100, ici de type MEMS ou NEMS, est tout d'abord réalisé sur un substrat 102 par exemple en semi-conducteur tel que du silicium.

Une portion sacrificielle 104 est ensuite réalisée sur le substrat 102 telle qu'elle recouvre le dispositif 100 et que son volume corresponde sensiblement à celui de la cavité 122 dans laquelle le dispositif 100 est destiné à être encapsulé (figure 1). La portion sacrificielle 104 est par exemple obtenue par la mise en oeuvre d'un dépôt d'une couche de matériau sacrificiel, par exemple une résine organique déposée par enduction centrifuge, dont l'épaisseur correspond à la hauteur souhaitée de la cavité 122, généralement comprise entre environ 1 µm et 10 µm et par exemple égale à environ 5 µm. La couche de matériau sacrificiel est ensuite soumise à une photolithographie et est gravée afin que seule la portion sacrificielle 104 soit conservée sur le substrat 102.

Comme représenté sur la figure 2, un capot 106 recouvrant la portion sacrificielle 104 (et recouvrant également, dans l'exemple décrit ici, la face supérieure du substrat 102 autour de la portion 104) est ensuite réalisé. Ce capot 106 comporte par exemple une couche minérale de SiO₂ d'épaisseur égale à environ 3 µm et déposée par PECVD. Au moins un trou 108 est réalisé à travers le capot 106, par exemple par photolithographie et gravure (ici une gravure ionique réactive, ou RIE). Ce trou 108 est destiné à servir à la gravure de la portion sacrificielle 104 qui sera mise en oeuvre pour libérer le dispositif 100 et former la cavité 122.

Une première couche 110 est ensuite formée sur le capot 106 de manière localisée dans le trou 108 et en recouvrant une première région du capot 106 localisée autour du trou 108. Pour cela, une résine photosensible est par exemple déposée sur le capot 106. Une photolithographie et une gravure sont ensuite mises en oeuvre afin de former au moins une ouverture dans la résine à l'emplacement souhaité pour la première couche 110. Le matériau de la première couche 110 est ensuite déposé sur la surface ainsi créée, c'est-à-dire sur la couche de résine et dans l'ouverture traversant la couche de résine. Enfin, par un procédé de type lift-off, la résine photosensible est éliminée en entraînant en même temps les parties de matériau recouvrant la résine. Le matériau conservé sur le capot 106 correspond la première couche 110 localisée dans l'ouverture formée précédemment dans la résine photosensible.

Dans le premier mode de réalisation décrit ici, dans lequel la première couche 110 recouvre la première région du capot 106 localisée autour du trou 108, le matériau de la première couche 110 est tel qu'il présente une force adhérence faible ou sensiblement nulle avec le ou les matériaux d'un clapet 114 destiné à être réalisé ensuite en regard du trou 108. Cette force d'adhérence est inférieure à environ 2 N/mm². Cette force d'adhérence sensiblement nulle ou faible est obtenue grâce au choix réalisé du matériau de la première couche 110 et de celui du clapet 114. Dans l'exemple de réalisation décrit ici, le matériau de la première couche 110 correspond à un polymère par exemple de type polytétrafluoroéthylène (PTFE) obtenu par un dépôt réalisé avec un plasma de gaz fluoré tel que du C₄F₈.

Sur la figure 3, une seule première couche 110 est réalisée sur le capot 106, recouvrant la première région du capot 106 localisée autour du trou 108. Une partie de la première couche 110 est également localisée dans le trou 108, recouvrant les parois latérales du trou 108 ainsi qu'une partie de la portion sacrificielle 104 se trouvant en regard du trou 108.

Une deuxième couche 112 à partir de laquelle le clapet 114 est destiné à être réalisé est ensuite déposée sur l'ensemble de la structure précédemment obtenue (figure 4). Le matériau de la deuxième couche 112 est par exemple de l'AlSi déposé par PVD. La deuxième couche 112 a par exemple une épaisseur égale à environ 1 µm. L'AlSi est un matériau qui a pour avantage de présenter une contrainte résiduelle de l'ordre de quelques centaines de MPa qui permettra au clapet 114 de présenter un gradient de contrainte dans son épaisseur de l'ordre de quelques dizaines de MPa et de former, après la réalisation du clapet 114, un espacement vis-à-vis du trou 108.

La deuxième couche 112 est ensuite soumise à une photolithographie et une gravure humide telles qu'une portion restante de la deuxième couche 112 forme le clapet 114. La clapet 114 comporte au moins une première partie 116 correspondant à la partie restante de la deuxième couche 112 qui est localisée sur la première couche 110, c'est-à-dire localisée en regard du trou 108 et de la première région du capot 106 recouverte par la première couche 110. Cette première partie 116 du clapet 114 n'est pas solidaire de, ou ancrée à, la première couche 110 en raison de l'adhérence faible ou sensiblement nulle entre le matériau de la première couche 110 (polymère) et celui du clapet 114 (AlSi dans l'exemple décrit ici). Le trou 108 n'est donc pas fermé hermétiquement ou de manière étanche par la première partie 116 du clapet 114.

Le clapet comporte également une deuxième partie 118 qui est en contact direct avec une deuxième région du capot 106 et solidarisée ou ancrée à cette deuxième région du capot 106. Les matériaux du clapet 114 et du capot 106 sont tels que la force d'adhérence entre la deuxième partie 118 du clapet 114 et le capot 106 est supérieure ou égale à environ 20 N/mm².

Ainsi, dans ce premier mode de réalisation, les matériaux du capot 106, de la première couche 110 et de la deuxième couche 112 sont choisis tels que la force d'adhérence entre les première et deuxième couches 110, 112 soit inférieure à environ 2 N/mm² et tels que la force d'adhérence entre la deuxième couche 112 et la deuxième région du capot 106 soit supérieure ou égale à environ 20 N/mm².

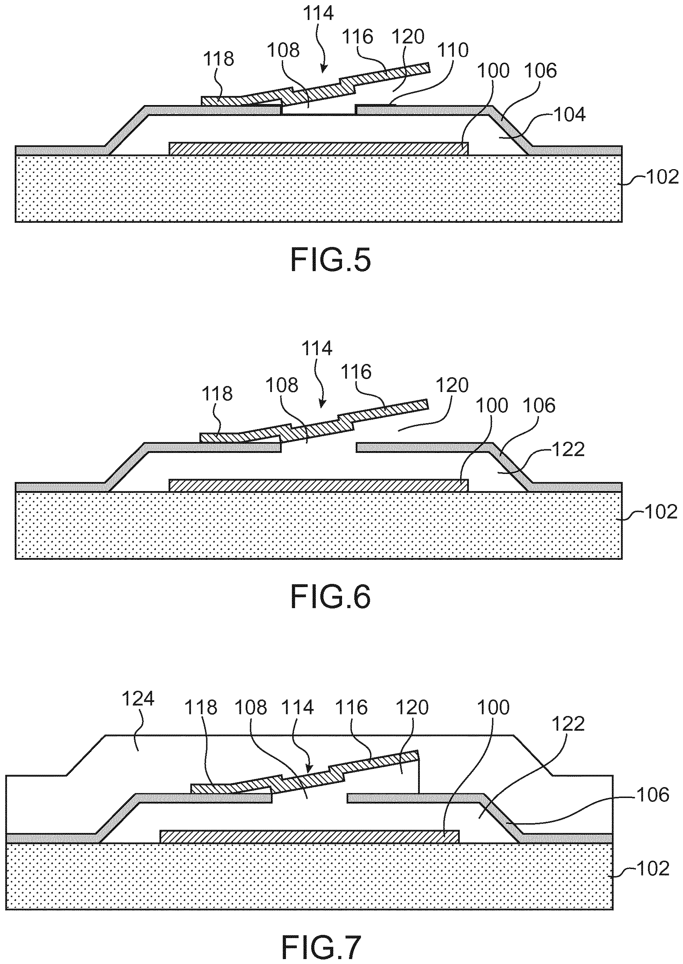

Sur l'exemple de la figure 5, la première partie 116 du clapet 114 correspond à une partie du clapet 114 formant un premier bord ou une première extrémité du clapet 114 mobile par rapport à un deuxième bord ou une deuxième extrémité du clapet 114 opposé au premier bord ou à la première extrémité du clapet 114 et formé par la deuxième partie 118.

Etant donné le gradient de contrainte auquel est soumis le clapet 114 (en raison de la contrainte résiduelle présente dans le matériau de la deuxième couche 112 déposée), et compte tenu de la force d'adhérence faible ou sensiblement nulle entre la première partie 116 du clapet 114 et la première couche 110 et de la force d'adhérence importante entre la deuxième partie 118 du clapet 114 et le capot 106, la première partie 116 du clapet 114 est déformée et forme un espace 120 entre la première couche 110 et la première partie 116 du clapet 114, facilitant l'accès au trou 108 et à la portion sacrificielle 104 depuis l'extérieur du capot 106. L'espace 120 forme un évent de libération facilitant l'accès au trou 108.

La première couche 110 et la portion sacrificielle 104 sont ensuite supprimées grâce à des agents de gravure, par exemple un ou plusieurs gaz de libération tels qu'un plasma O₂, mis en contact avec la première couche 110 et la portion sacrificielle 104 depuis l'accès formé par l'espace 120 et par l'intermédiaire du trou 108. La suppression de la portion sacrificielle 104 forme la cavité 122 dans laquelle le dispositif microélectronique 100 est encapsulé (figure 6).

La cavité 122 est ensuite bouchée en déposant un matériau de bouchage 124, ici sous la forme d'une couche recouvrant sur l'ensemble de la structure réalisée (figure 7). Etant donné que l'accès à la cavité 122 se fait par l'intermédiaire du trou 108 et de l'espace 120 formé sous la première partie 116 du clapet 114, et du fait que la déformation de la première partie 116 du clapet 114 est telle que la première partie 116 du clapet 114 reste disposée en regard du trou 108, le matériau de bouchage 124 recouvre le capot 106 et le clapet 114 sans risque de dépôt résiduel du matériau de bouchage 124 à l'intérieur de la cavité 122. La couche de matériau de bouchage 124 est réalisée de manière suffisamment épaisse pour qu'elle obstrue l'accès à l'espace 120 et ferme ainsi hermétiquement la cavité 122. Le matériau de bouchage 124 peut être déposé par un dépôt de type CVD, PVD, ou encore un dépôt par enduction centrifuge. Le matériau de bouchage 124 est par exemple du BCB (Benzo-Cyclo-Butène).

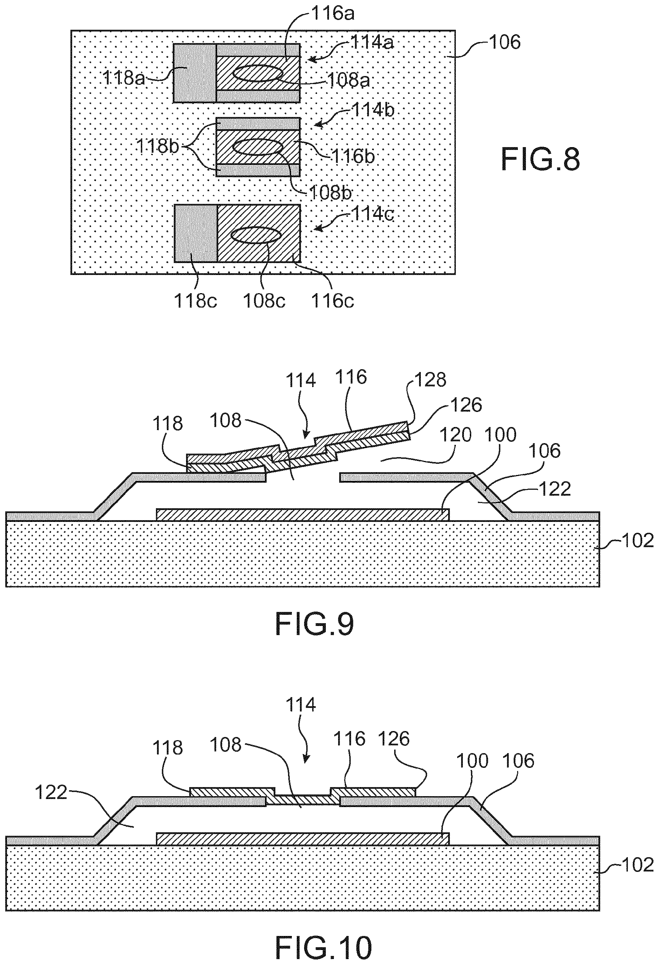

Différentes configurations du clapet 114 et de la première couche 110 sont possibles. La figure 8 représente trois exemples de réalisation du clapet 114 et de la première couche 110. Pour les trois clapets 114a, 114b et 114c représentés sur la figure 8, la partie hachurée correspond à la première partie respectivement référencée 116a, 116b et 116c de chacun des clapets 114a, 114b, 114c, c'est-à-dire la partie du clapet localisée en regard de la première couche 110.

Chacun des clapets 114a, 114b, 114c comporte une portion issue de la deuxième couche 112 et de section, dans un plan parallèle à celui passant par la face supérieure du capot 106 sur laquelle le clapet 114a est réalisé, rectangulaire. De plus, pour les trois exemples de réalisation représentés sur la figure 8, la première couche 110 (non visible sur la figure 8) a une de section, dans un plan parallèle à celui passant par la face supérieure du capot 106, rectangulaire et est formée autour de chacun des trous respectivement référencés 108a, 108b et 108c. Ainsi, du fait que la première couche 110 est similaire dans les trois exemples de réalisation représentés sur la figure 8, les clapets 114a, 114b, 114c comportent des premières parties 116a, 116b, 116c de forme et de dimensions similaires les unes des autres.

L'ancrage du premier clapet 114a au capot 106 est obtenu par les parties de la portion de matériau du clapet 114a formant la deuxième partie 118a du clapet 114a, ces parties étant localisées sur trois côtés de la portion de matériau rectangulaire formant le clapet 114a. Ainsi, l'espace 120 formé entre la première partie 116a du clapet 114a et la première couche 110 forme un canal borgne délimité par la deuxième partie 118a du clapet 114a sur trois côtés au niveau desquels le clapet 114a est ancré au capot 106.

L'ancrage du deuxième clapet 114b au capot 106 est obtenu par les parties de la portion de matériau du clapet 114b formant la deuxième partie 118b du clapet 114b et localisées sur deux côtés opposés de la portion de matériau rectangulaire formant le clapet 114b. Ainsi, l'espace 120 obtenu entre la première partie 116b du clapet 114b et la première couche 110 forme un canal délimité par la deuxième partie 118b sur deux côtés opposés au niveau desquels le clapet 114b est ancré au capot 106.

Enfin, l'ancrage du troisième clapet 114c au capot 106 est obtenu par la partie de la portion de matériau du clapet 114c formant la deuxième partie 118c du clapet 114c et localisée sur un seul côté de la portion de matériau rectangulaire formant le clapet 114c. Ainsi, le clapet 114c forme une poutre dont une première extrémité, correspondant à la deuxième partie 118c, est solidarisée au capot 106 et dont une deuxième extrémité, opposée à la première extrémité et formée par la première partie 116c, est espacée du capot 106 et de la première couche 110.

Dans le premier mode de réalisation précédemment décrit, le clapet 114 est réalisé à partir d'une couche d'un seul matériau présentant une contrainte résiduelle telle que la première partie 118 du clapet 114 est espacée de la première couche 110 lors de la gravure de la portion sacrificielle 104 et lors du dépôt du matériau de bouchage 124.

Selon une première variante, le clapet 114 peut être réalisé à partir d'une deuxième couche 112 correspondant à un multicouche composé de matériaux différents ayant des propriétés mécaniques différentes les uns des autres.

La figure 9 représente un exemple de clapet 114 comportant deux matériaux ayant des contraintes résiduelles différentes. Par exemple, le clapet 114 comporte une couche 126 d'un premier matériau, ici du SiO₂ déposé par PECVD et dont l'épaisseur peut être comprise entre environ 1 µm et 2 µm. Cette couche 126 a une contrainte résiduelle en compression faible, par exemple comprise entre environ 20 MPa et 100 MPa. Le clapet 114 comporte également une couche 128 correspondant ici à un empilement de plusieurs métaux déposés par PVD. A titre d'exemple, cet empilement de métaux peut comporter une sous-couche de titane d'épaisseur par exemple égale à environ 20 nm, et une couche de nickel d'épaisseur par exemple égale à environ 400 nm. La sous-couche de titane permet d'améliorer l'adhérence de la couche de nickel sur la couche 126.

La couche de nickel possède une contrainte résiduelle en tension importante, par exemple comprise entre environ 100 MPa et 1000 MPa. La contrainte résiduelle en tension du nickel présent dans la couche 128 du clapet 114 s'ajoute à la contrainte résiduelle en compression de la couche 126 du clapet 114. Ainsi, en considérant la contrainte résiduelle globale à laquelle le clapet 114 est soumis, celle-ci va déformer de la première partie 116 du clapet 114 et former l'espace 120 entre la première partie 116 du clapet 114 et le capot 106.

Les contraintes résiduelles des couches 126, 128 sont obtenues en raison des matériaux utilisés, mais peuvent également être accentuées ou réduites via les paramètres de dépôt (température, vitesse, puissance de plasma, etc.) utilisés lors du dépôt des couches 126, 128. Des traitements thermiques ultérieurs à ces dépôts peuvent également contribuer à l'obtention des contraintes résiduelles souhaitées.

Le soulèvement de la première partie 116 du clapet 114 peut être relativement important de façon à pouvoir augmenter l'ouverture formée par l'espace 120 afin d'accélérer la libération du dispositif 100, c'est-à-dire la gravure de la portion sacrificielle 104.

Une fois cette libération achevée, la couche la plus contrainte du clapet 114, c'est-à-dire la couche 128 dans l'exemple décrit ci-dessus, peut être éliminée. Le clapet 114, qui ne comporte alors que de la ou des couches restantes à l'issue de cette gravure, ici la couche 126, se relaxe alors sous sa forme la moins contrainte en revenant à sa position initiale (ou légèrement déformée selon les contraintes résiduelles dans les matériaux des couches restantes). La couche 128 peut être supprimée en mettant en oeuvre une gravure sèche. Dans le cas décrit ci-dessous, la couche 128 correspond à un empilement d'une sous-couche de titane et d'une couche de nickel. Etant donné que la déformation de la première partie 116 du clapet 114 est due à la contrainte résiduelle en tension apportée par la couche de nickel, il est envisageable que seule la couche de nickel soit supprimée pour que le clapet 114 retrouve sa position initiale. De manière générale, la gravure mise en oeuvre pour supprimer le ou les matériaux à l'origine de la déformation du clapet 114 est sélective vis-à-vis des matériaux présents afin notamment d'éviter de dégrader le dispositif 100.

Ainsi, le clapet 114 se rabaisse vers le capot 106, réduisant les dimensions de l'espace 120, voire le supprimant comme sur l'exemple de la figure 10 sur laquelle le clapet 114 n'est formé plus que de la couche 126 qui bouche complètement le trou 108. Cela permet de faciliter la fermeture hermétique de la cavité 122 obtenue en déposant le matériau de bouchage 124.

Selon une deuxième variante, le clapet 114 peut être réalisé à partir de plusieurs couches de matériaux différents ayant des propriétés thermomécaniques différentes. Dans ce cas, un clapet 114 similaire à celui représenté sur la figure 9 est réalisé. Par contre, les couches 126, 128 n'ont dans ce cas pas des contraintes résiduelles différentes mais des coefficients de dilatation thermique différents. Lors de la gravure de la portion sacrificielle 104, le clapet 114 est soumis à une température suffisante pour engendrer un soulèvement de sa première partie 116 et former l'espace 120 facilitant l'accès au trou 108 et à la portion sacrificielle 104.

Selon cette deuxième variante de réalisation, la couche 126 du clapet 114, c'est-à-dire celle se trouvant entre le capot 106 et la couche 128, comporte un premier matériau ayant un coefficient de dilatation thermique supérieur à celui d'un deuxième matériau de la couche 128. Le tableau ci-dessous donne plusieurs exemples de métaux pouvant être utilisés pour réaliser les couches 126, 128 du clapet 114, ainsi que les valeurs des coefficients de dilatation thermique α de ces matériaux :

| **Métal** | **α (10⁻⁶/°C)** |
|---|---|
| Al | 23,1 |
| Cu | 16,5 |
| Ni | 13,4 |
| Pt | 8,8 |
| Ti | 8,6 |
| Zr | 5,7 |

Par exemple, la couche 126 peut comporter de l'aluminium et la couche 128 peut comporter du titane. Dans ce cas, lorsque la gravure de la portion sacrificielle 104 est mise en oeuvre à une température suffisamment élevée, généralement supérieur à environ 100°C et par exemple de l'ordre de 200°C, la première partie 116 du clapet 114 se déforme alors, créant l'espace 120 facilitant le passage des agents de gravure vers la portion sacrificielle 104. Une fois la gravure de la portion sacrificielle 104 achevée, la structure d'encapsulation obtenue est soumise à la température ambiante, permettant au clapet 114 de reprendre sa position initiale non déformée. Le bouchage hermétique de la cavité 112 peut ensuite être réalisé via le dépôt du matériau de bouchage 124. Lorsque le bouchage est réalisé à une température supérieure à celle déformant la première partie 116 du clapet 114, une des couches du clapet 114, par exemple la couche 128, participant à sa déformation peut être supprimée avant la mise en oeuvre de ce bouchage afin d'éviter que le clapet 114 soit déformé lors du bouchage. Lorsque le bouchage est réalisé à une température inférieure à celle déformant le clapet 114, les matériaux du clapet 114 ayant différents coefficients de dilatation thermique peuvent être conservés. Lorsque la couche 126 est en titane, ou plus généralement à base d'un matériau getter, compte tenu des propriétés getter de ce matériau, c'est-à-dire de son aptitude à adsorber et/ou absorber des molécules gazeuses telles que des molécules de H₂O, H₂, CO, CO₂, N₂, O₂, il est possible d'ajuster la pression finale dans la cavité 122 en activant le matériau de la couche 126 par un chauffage à une température supérieure ou égale à sa température d'activation, généralement comprise entre environ 250°C et 400°C.

Les deux variantes précédemment décrites peuvent être combinées l'une avec l'autre. Ainsi, le clapet 114 peut être réalisé à partir de plusieurs couches de matériaux présentant des contraintes résiduelles différentes mais également des coefficients de dilatation thermique différents. Cela peut notamment être obtenu en réalisant chacune des première et deuxième couches 126, 128 comme un multicouche, ou un empilement de plusieurs matériaux différents. Ainsi, une déformation suffisante du clapet 114 peut être tout de même obtenue en combinant la déformation due à l'effet des contraintes résiduelles des matériaux en présence et celle due à l'effet de dilatation thermique de ces matériaux, et cela même si la température à laquelle la gravure de la portion sacrificielle 104 est limitée ou si les matériaux formant le clapet 114 présentent des contraintes résiduelles ou des coefficients de dilatation thermique modérés.

Selon une autre variante, il est possible que le ou les matériaux du clapet 114 ne comportent ni contrainte résiduelle ni des coefficients de dilatation thermique différents. Ainsi, après la gravure de la deuxième couche 112 formant le clapet 114, celui-ci ne se déforme pas et la première partie 116 du clapet 114 reste disposée contre la première couche 110. Toutefois, étant donné la force d'adhérence faible ou sensiblement nulle entre les matériaux des première et deuxième couches 110, 112, la première partie 116 du clapet 114 ne ferme pas le trou 108 de manière hermétique ou étanche. Ainsi, les fuites existantes entre la première partie 116 du clapet 114 et la première couche 110 permettent aux agents de gravure de passer entre la première couche 110 et la première partie 116 du clapet 114 et de graver la première couche 110 et la portion sacrificielle 104.

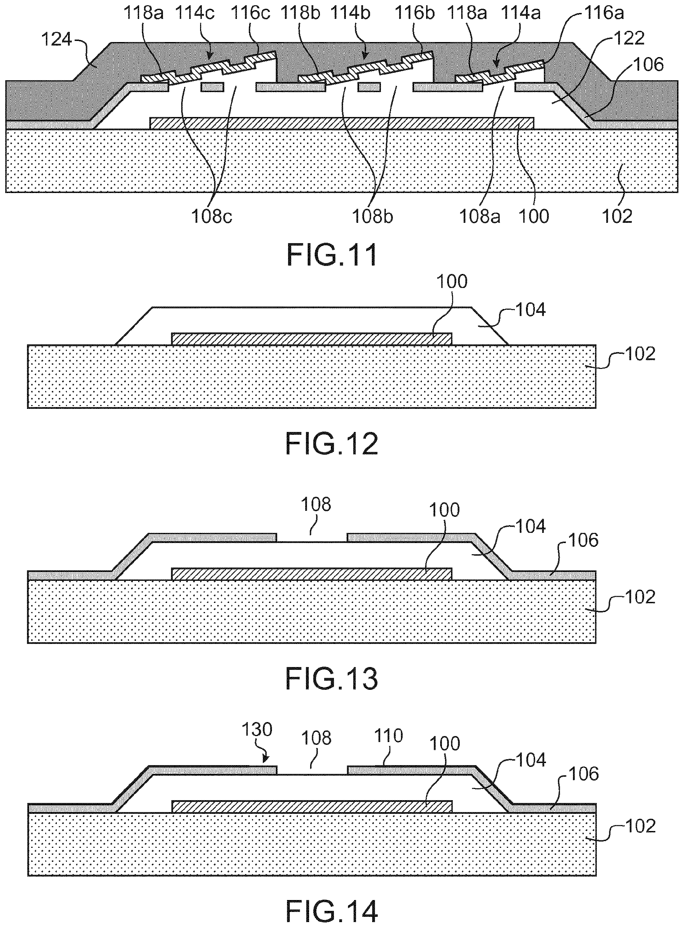

En outre, plusieurs trous 108 peuvent être réalisés à travers le capot 106 et plusieurs clapets 114 peuvent être réalisés sur un même capot 106. De plus, il est également possible qu'un clapet 114 soit réalisé tel que la première partie 116 de ce clapet 114 soit disposée en regard de plusieurs trous 108. La figure 11 représente plusieurs trous 108 réalisés à travers le capot 106. Un premier trou 108a est formé à travers le capot 106 et un premier clapet 114a est réalisé tel que sa première partie 116a soit disposée en regard de ce trou 108a. Deux deuxièmes trous 108b sont réalisés à travers le capot 106 et un deuxième clapet 114b, commun à ces deux trous 108b, est réalisé tel que sa première partie 116b soit disposée en regard de ces deux trous 108b. Deux troisièmes trous 108c sont réalisés à travers le capot 106 et un troisième clapet 114c, commun à ces trous 108c, est réalisé tel que sa première partie 116c soit disposée en regard de ces deux trous 108c.

Un procédé de réalisation de la cavité fermée 122 servant à réaliser une encapsulation du dispositif microélectronique 100 selon un deuxième mode de réalisation est décrit ci-dessous en lien avec les figures 12 à 18.

Comme précédemment décrit pour le premier mode de réalisation, le dispositif microélectronique 100 est tout d'abord réalisé sur le substrat 102. La portion sacrificielle 104 est ensuite réalisée sur le substrat 102 telle qu'elle recouvre le dispositif 100 et que son volume corresponde sensiblement à celui de la cavité 122 dans laquelle le dispositif 100 est destiné à être encapsulé (figure 12). Le capot 106 recouvrant la portion sacrificielle 104 est ensuite réalisé. Au moins un trou 108 est réalisé à travers le capot 106 (figure 13).

A l'inverse du premier mode de réalisation dans lequel le matériau du clapet 114 déposé sur le capot 106 présente une force d'adhérence importante avec celui du capot 106, et dans lequel la première couche 110 est formée sur le capot 106 en recouvrant la première région du capot 106 localisée autour du trou 108 et telle que la force d'adhérence entre la première couche 110 et la première partie 116 du clapet 114 soit faible ou sensiblement nulle, le clapet 114 est ici réalisé à partir d'au moins un matériau ayant, vis-à-vis du capot 106, une force d'adhérence sensiblement nulle ou faible. La solidarisation entre le capot 106 et la deuxième partie 118 du clapet 114 est obtenue grâce à la première couche 110 qui ne recouvre pas la première région du capot mais qui est formée autour de cette première région. La première couche 110 comporte un matériau tel qu'une force d'adhérence entre la première couche 110 et la deuxième partie 118 du clapet 114 soit importante, par exemple supérieure ou égale à environ 20 N/mm², permettant l'ancrage du clapet 114 au capot 106.

Sur la figure 14, la première couche 110 est donc déposée sur l'ensemble du capot 106, puis est gravée afin de supprimer la partie de cette première couche 110 localisée au niveau de la première région du capot 106 en regard de laquelle la première partie 116 du clapet 114 est destinée à être disposée. Dans l'exemple décrit ici, la première couche 110 peut comporter du titane déposé par PVD sur le capot 106, puis une photolithographie et une gravure sèche de type ionique réactive, ou RIE, est mise en oeuvre pour former dans la première couche 110 une ouverture 130 disposée en regard de la première région du capot 106 au niveau de laquelle la première partie 116 du clapet 114 est destinée à être localisée.

Sur l'exemple de la figure 14, seules les parties de la première couche 110 localisées au niveau de la première région du capot 106 sont gravées. Selon un autre exemple de mise en oeuvre, il est possible que la première couche 110 soit gravée telle qu'une portion restante localisée uniquement au niveau de la deuxième région du capot 106 au niveau de laquelle la deuxième partie 118 du clapet 114 est destinée à être ancrée, soit uniquement conservée.

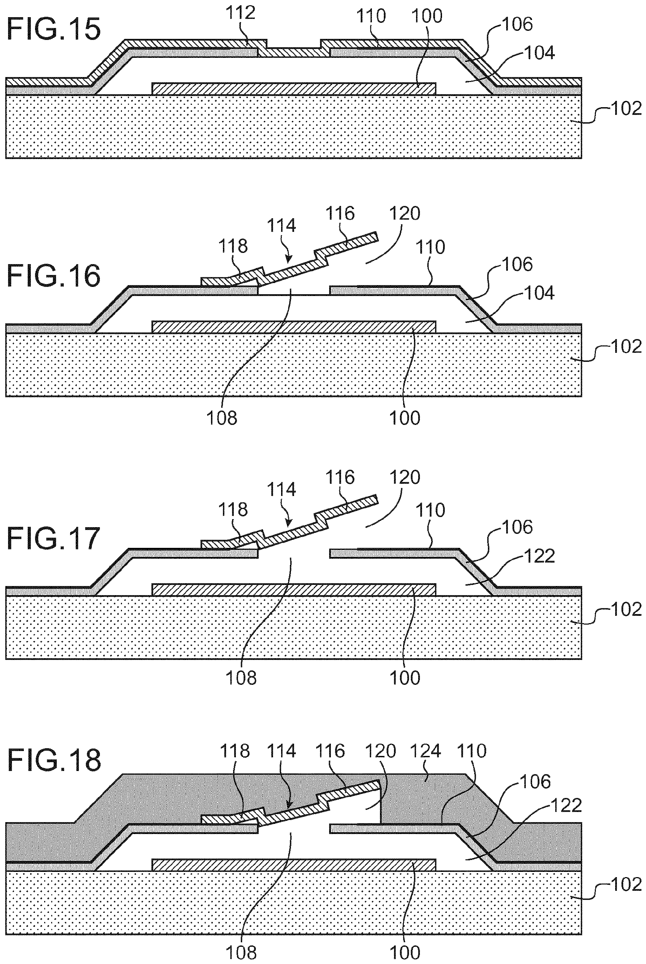

La deuxième couche 112 à partir de laquelle le clapet 114 est réalisé est ensuite déposée sur l'ensemble de la structure précédemment obtenue (figure 15). La deuxième couche 112 est par exemple formée d'un bicouche comportant une première couche d'Au d'épaisseur par exemple égale à environ 1 µm déposé par PVD ou par évaporation sans contrainte résiduelle sur la première couche 110, sur la première région du capot 106 localisée en regard de l'ouverture 130 ainsi que dans le trou 108, et comportant également une deuxième couche de titane d'épaisseur par exemple égale à environ 20 nm ayant une contrainte résiduelle en tension de l'ordre d'une centaine de MPa et déposée sur la première couche d'Au.

Dans ce deuxième mode de réalisation, lorsque le capot 106 comporte par exemple du SiO₂ et que le clapet 114 est réalisé à partir d'une deuxième couche 112 comportant un métal noble tel que de l'Au, du Pt ou encore du Ni, la première couche 110 peut comporter du métal tel que du Ti.

La deuxième couche 112 est ensuite soumise à une photolithographie et une gravure humide telles qu'une portion restante de la deuxième couche 112 forme le clapet 114 (figure 16). La deuxième partie 118 du clapet 114 est en contact avec la première couche 110 et est ainsi solidarisée ou ancrée au capot 106 par l'intermédiaire de la première couche 110.

La portion sacrificielle 104 est ensuite supprimée grâce à des agents de gravure, par exemple un ou plusieurs gaz de libération tels qu'un plasma O₂, mis en contact avec la portion sacrificielle 104 depuis l'accès formé par l'espace 120 et le trou 108. La suppression de la portion sacrificielle 104 forme la cavité 122 dans laquelle le dispositif microélectronique 100 est encapsulé (figure 17).

La cavité 122 est ensuite fermée en déposant le matériau de bouchage 124 sur l'ensemble de la structure réalisée, comme précédemment décrit pour le premier mode de réalisation (figure 18).

Les différentes variantes de réalisation précédemment décrites pour le premier mode de réalisation (réalisation du clapet 114 à partir d'un ou plusieurs matériaux ayant ou non des contraintes résiduelles et/ou des coefficients de dilatation thermique différents, réalisation de plusieurs trous 108 et/ou plusieurs clapets 114 sur le capot 106) peuvent s'appliquer également au deuxième mode de réalisation et permettent d'obtenir les mêmes avantages que ceux décrits précédemment pour le premier mode de réalisation.

## Revendications

1. Procédé de réalisation d'au moins une cavité (122) fermée, comportant au moins les étapes suivantes :
- réalisation d'une portion sacrificielle (104) sur un substrat (102) ;
- réalisation d'un capot (106) recouvrant la portion sacrificielle (104) ;
- réalisation d'au moins un trou (108) à travers le capot (106) ;
- réalisation, sur le capot (106), d'une première couche (110) telle que, selon une première configuration, la première couche (110) recouvre au moins une première région du capot (106) localisée autour du trou (108), ou selon une deuxième configuration, la première couche (110) entoure la première région du capot (106) ;
- dépôt d'au moins une deuxième couche (112) recouvrant le capot (106) et la première couche (110) et telle que, selon la première configuration, une force d'adhérence entre les première et deuxième couches (110, 112) est inférieure à une force d'adhérence entre la deuxième couche (112) et une deuxième région du capot (106) juxtaposée à la première région du capot (106) ou, selon la deuxième configuration, une force d'adhérence entre la deuxième couche (112) et la première région du capot (106) est inférieure à une force d'adhérence entre les première et deuxième couches (110, 112) ;
- gravure de la deuxième couche (112) telle qu'une portion restante de la deuxième couche (112) forme au moins un clapet (114) dont une première partie (116) localisée en regard du trou (108) et de la première région du capot (106) ne ferme pas le trou (108) hermétiquement ou de manière étanche, et dont une deuxième partie (118) est solidaire de la deuxième région du capot (106) ;
- gravure de la portion sacrificielle (104) à travers le trou (108), formant la cavité (122) entre le capot (106) et le substrat (102) ;
- fermeture de la cavité (122) par un dépôt d'un matériau de bouchage (124) au moins sur la première partie (116) du clapet (114) et au moins une partie du capot (106) autour de la première région du capot (106).

2. Procédé selon la revendication 1, dans lequel, selon la première configuration, le clapet (114) adhère à la deuxième région du capot (106) et n'adhère pas à la première couche (110) ou, selon la deuxième configuration, le clapet (114) adhère à la première couche (110) et n'adhère pas à la première région du capot (106).

3. Procédé selon l'une des revendications précédentes, dans lequel, selon la première configuration, la force d'adhérence entre les première et deuxième couches (110, 112) est inférieure à environ 2 N/mm² ou, selon la deuxième configuration, la force d'adhérence entre la deuxième couche (112) et la première région du capot (106) est inférieure à environ 2 N/mm².

4. Procédé selon l'une des revendications précédentes, dans lequel, selon la première configuration, une partie de la première couche (110) est disposée dans le trou (108), et dans lequel la gravure de la portion sacrificielle (104) est précédée d'une gravure d'au moins la partie de la première couche (110) disposée dans le trou (108).

5. Procédé selon l'une des revendications précédentes, dans lequel, selon la première configuration, la force d'adhérence entre la deuxième couche (112) et la deuxième région du capot (106) est supérieure ou égale à environ 20 N/mm² ou, selon la deuxième configuration, la force d'adhérence entre les première et deuxième couches (110, 112) est supérieure ou égale à environ 20 N/mm².

6. Procédé selon l'une des revendications précédentes, dans lequel, selon la première configuration, la première couche (110) comporte au moins un polymère, ou, selon la deuxième configuration, la première couche (110) comporte au moins un métal.

7. Procédé selon l'une des revendications précédentes, dans lequel la deuxième couche (112) a une contrainte résiduelle engendrant, après la gravure de la deuxième couche (112), une déformation de la première partie (116) du clapet (114) espaçant la première partie (116) du clapet (114) vis-à-vis de la première région du capot (106) et telle que la première partie (116) du clapet (114) reste disposée en regard du trou (108).

8. Procédé selon l'une des revendications 1 à 6, dans lequel la deuxième couche (112) comporte au moins des premier et deuxième matériaux (126, 128) distincts, superposés tels que le premier matériau (126) soit disposé entre le deuxième matériau (128) et le capot (106), et ayant des contraintes résiduelles de valeurs et/ou de types différents engendrant, après la gravure de la deuxième couche (112), une déformation de la première partie (116) du clapet (114) espaçant la première partie (116) du clapet (114) vis-à-vis de la première région du capot (106).

9. Procédé selon la revendication 8, comportant en outre, entre la gravure de la portion sacrificielle (104) et la fermeture de la cavité (122), une étape de gravure d'au moins une partie du deuxième matériau (128).

10. Procédé selon l'une des revendications 8 ou 9, dans lequel le premier matériau (126) et/ou le deuxième matériau (128) comporte une contrainte résiduelle.

11. Procédé selon la revendication 10, dans lequel la contrainte résiduelle est une contrainte en compression ou en tension.

12. Procédé selon l'une des revendications 8 à 11, dans lequel le premier matériau (126) comporte du SiO₂ et le deuxième matériau (128) comporte du nickel.

13. Procédé selon l'une des revendications 8 à 12, dans lequel le deuxième matériau (128) comporte un empilement de titane et de nickel tel que le titane soit disposé entre le premier matériau (126) et le nickel.

14. Procédé selon l'une des revendications précédentes, dans lequel la deuxième couche (112) comporte au moins des premier et deuxième matériaux (126, 128) distincts et superposés tels que le premier matériau (126) soit disposé entre le deuxième matériau (128) et le capot (106), le premier matériau (126) ayant un coefficient de dilatation thermique supérieur à celui du deuxième matériau (128), et dans lequel la gravure de la portion sacrificielle (104) est mise en oeuvre à une température engendrant une déformation de la première partie (116) du clapet (114) due à la dilatation thermique des premier et deuxième matériaux (126, 128), espaçant la première partie (116) du clapet (114) vis-à-vis de la première région du capot (106).

15. Procédé selon la revendication 14, dans lequel le premier matériau (126) comporte de l'aluminium et le deuxième matériau (128) comporte du titane.

16. Procédé selon l'une des revendications 14 ou 15, dans lequel le dépôt du matériau de bouchage (124) est mis en oeuvre à température ambiante.

17. Procédé selon l'une des revendications précédentes, dans lequel la deuxième couche (112) comporte au moins un matériau getter.

18. Procédé selon l'une des revendications précédentes, dans lequel plusieurs trous (108) sont réalisés à travers le capot (106) et :
- la première partie (116) du clapet (114) est localisée en regard d'au moins deux desdits trous (108), et/ou
- la gravure de la deuxième couche (112) forme plusieurs clapets (114) tels que la première partie (116) de chacun des clapets (114) soit disposée en regard d'au moins un desdits trous (108).

19. Procédé selon l'une des revendications précédentes, dans lequel la portion sacrificielle (104) est réalisée sur le substrat (102) telle qu'elle recouvre au moins un dispositif microélectronique (100) disposé sur le substrat (102), le dispositif microélectronique (100) étant encapsulé dans la cavité (122) fermée à l'issu du procédé.

20. Procédé selon la revendication 19, dans lequel les étapes mises en oeuvre réalisent une encapsulation collective de plusieurs dispositifs microélectroniques (100) disposés sur le substrat (102).

## Patentansprüche

1. Verfahren zur Herstellung wenigstens eines geschlossenen Hohlraums (122), umfassend wenigstens die folgenden Schritte:
- Realisieren eines Opferbereichs (104) auf einem Substrat (102);
- Realisieren eines Deckels (106), der den Opferbereich (104) bedeckt;
- Realisieren wenigstens eines Lochs (108) durch den Deckel (106);
- Realisieren einer ersten Schicht (110) auf dem Deckel (106) derart, dass gemäß einer ersten Konfiguration die erste Schicht (110) wenigstens eine erste Region des Deckels (106) bedeckt, die um das Loch (108) herum lokalisiert ist, oder gemäß einer zweiten Konfiguration die erste Schicht (110) die erste Region des Deckels (106) umgibt;
- Aufbringen wenigstens einer zweiten Schicht (112), die den Deckel (106) und die erste Schicht (110) bedeckt, derart, dass gemäß der ersten Konfiguration eine Adhäsionskraft zwischen der ersten und der zweiten Schicht (110, 112) kleiner ist als eine Adhäsionskraft zwischen der zweiten Schicht (112) und einer zweiten Region des Deckels (106), die neben der ersten Region des Deckels (106) angeordnet ist, oder gemäß der zweiten Konfiguration eine Adhäsionskraft zwischen der zweiten Schicht (112) und der ersten Region des Deckels (106) kleiner ist als eine Adhäsionskraft zwischen der ersten und der zweiten Schicht (110, 112);
- Ätzen der zweiten Schicht (112) derart, dass ein verbleibender Bereich der zweiten Schicht (112) wenigstens eine Klappe (114) bildet, von der ein erster Teil (116), der gegenüber dem Loch (108) und der ersten Region des Deckels (106) lokalisiert ist, das Loch (108) nicht hermetisch oder dicht schließt, und von der ein zweiter Teil (118) mit der zweiten Region des Deckels (106) verbunden ist;
- Ätzen des Opferbereichs (104) durch das Loch (108) zum Bilden des Hohlraums (122) zwischen dem Deckel (106) und dem Substrat (102);
- Schließen des Hohlraums (122) durch Aufbringen eines Verschlussmaterials (124) wenigstens auf den ersten Teil (116) der Klappe (114) und wenigstens einen Teil des Deckels (106) um die erste Region des Deckels (106) herum.

2. Verfahren nach Anspruch 1, bei dem gemäß der ersten Konfiguration die Klappe (114) an der zweiten Region des Deckels (106) haftet und nicht an der ersten Schicht (110) haftet, oder gemäß der zweiten Konfiguration die Klappe (114) an der ersten Schicht (110) haftet und nicht an der ersten Region des Deckels (106) haftet.

3. Verfahren nach einem der vorhergehenden Ansprüche, bei dem gemäß der ersten Konfiguration die Adhäsionskraft zwischen der ersten und der zweiten Schicht (110, 112) kleiner ist als ungefähr 2 N/mm², oder gemäß der zweiten Konfiguration die Adhäsionskraft zwischen der zweiten Schicht (112) und der ersten Region des Deckels (106) kleiner als ungefähr 2 N/mm² ist.

4. Verfahren nach einem der vorhergehenden Ansprüche, bei dem gemäß der ersten Konfiguration ein Teil der ersten Schicht (110) in dem Loch (108) angeordnet ist, und bei dem dem Ätzen des Opferbereichs (104) ein Ätzen wenigstens des Teils der ersten Schicht (110) vorhergeht, der in dem Loch (108) angeordnet ist.

5. Verfahren nach einem der vorhergehenden Ansprüche, bei dem gemäß der ersten Konfiguration die Adhäsionskraft zwischen der zweiten Schicht (112) und der zweiten Region des Deckels (106) größer oder gleich ungefähr 20 N/mm² ist, oder gemäß der zweiten Konfiguration die Adhäsionskraft zwischen der ersten und der zweiten Schicht (110, 112) größer oder gleich ungefähr 20 N/mm² ist.

6. Verfahren nach einem der vorhergehenden Ansprüche, bei dem gemäß der ersten Konfiguration die erste Schicht (110) wenigstens ein Polymer enthält, oder gemäß der zweiten Konfiguration die erste Schicht (110) wenigstens ein Metall enthält.

7. Verfahren nach einem der vorhergehenden Ansprüche, bei dem die zweite Schicht (112) eine Restspannung hat, die nach dem Ätzen der zweiten Schicht (112) eine Verformung des ersten Teils (116) der Klappe (114) bewirkt, die den ersten Teil (116) der Klappe (114) von der ersten Region des Deckels (106) beabstandet, und derart, dass der erste Teil (116) der Klappe (114) gegenüber dem Loch (108) angeordnet bleibt.

8. Verfahren nach einem der Ansprüche 1 bis 6, bei dem die zweite Schicht (112) wenigstens ein erstes und ein zweites unterschiedliches Material (126, 128) enthält, die derart überlagert sind, dass das erste Material (126) zwischen dem zweiten Material (128) und dem Deckel (106) angeordnet ist, und die Restspannungen mit unterschiedlichen Werten und/oder Typen haben, die nach dem Ätzen der zweiten Schicht (112) eine Verformung des ersten Teils (116) der Klappe (114) bewirken, die den ersten Teil (116) der Klappe (114) von der ersten Region des Deckels (106) beabstandet.

9. Verfahren nach Anspruch 8, ferner umfassend zwischen dem Ätzen des Opferbereichs (104) und dem Schließen des Hohlraums (122) einen Schritt des Ätzens wenigstens eines Teils des zweiten Materials (128).

10. Verfahren nach einem der Ansprüche 8 oder 9, bei dem das erste Material (126) und/oder das zweite Material (128) eine Restspannung besitzt.

11. Verfahren nach Anspruch 10, bei dem die Restspannung eine Kompressions- oder Zugspannung ist.

12. Verfahren nach einem der Ansprüche 8 bis 11, bei dem das erste Material (126) SiO₂ umfasst, und das zweite Material (128) Nickel umfasst.

13. Verfahren nach einem der Ansprüche 8 bis 12, bei dem das zweite Material (128) einen Stapel aus Titan und Nickel derart umfasst, dass das Titan zwischen dem ersten Material (126) und dem Nickel angeordnet ist.

14. Verfahren nach einem der vorhergehenden Ansprüche, bei dem die zweite Schicht (112) wenigstens ein erstes und ein zweites unterschiedliches Material (126, 128) umfasst, die derart überlagert sind, dass das erste Material (126) zwischen dem zweiten Material (128) und dem Deckel (106) angeordnet ist, wobei das erste Material (126) einen thermischen Ausdehnungskoeffizienten hat, der größer als jener des zweiten Materials (128) ist, und bei dem das Ätzen des Opferbereichs (104) bei einer Temperatur durchgeführt wird, die eine Verformung des ersten Teils (116) der Klappe (114) aufgrund der thermischen Ausdehnung des ersten und des zweiten Materials (126, 128) bewirkt, die den ersten Teil (116) der Klappe (114) von der ersten Region des Deckels (106) beabstandet.

15. Verfahren nach Anspruch 14, bei dem das erste Material (126) Aluminium enthält, und das zweite Material (128) Titan enthält.

16. Verfahren nach einem der Ansprüche 14 oder 15, bei dem das Aufbringen des Verschlussmaterials (124) bei Umgebungstemperatur durchgeführt wird.

17. Verfahren nach einem der vorhergehenden Ansprüche, bei dem die zweite Schicht (112) wenigstens ein Gettermaterial enthält.

18. Verfahren nach einem der vorhergehenden Ansprüche, bei dem mehrere Löcher (108) durch den Deckel (106) realisiert werden, und:
- der erste Teil (116) der Klappe (114) gegenüber wenigstens zwei der Löcher (108) lokalisiert ist, und/oder
- das Ätzen der zweiten Schicht (112) mehrere Klappen (114) derart bildet, dass der erste Teil (116) von jeder der Klappen (114) gegenüber wenigstens einem der Löcher (108) angeordnet ist.

19. Verfahren nach einem der vorhergehenden Ansprüche, bei dem der Opferbereich (104) auf dem Substrat (102) derart realisiert wird, dass er wenigstens eine mikroelektronische Vorrichtung (100) bedeckt, die auf dem Substrat (102) angeordnet ist, wobei die mikroelektronische Vorrichtung (100) in dem Hohlraum (122) eingekapselt ist, der am Ende des Verfahrens geschlossen wird.

20. Verfahren nach Anspruch 19, bei dem die durchgeführten Schritte eine kollektive Einkapselung von mehreren mikroelektronischen Vorrichtungen (100) realisieren, die auf dem Substrat (102) angeordnet sind.

## Claims

1. Method for making at least one closed cavity (122), comprising at least the following steps:
- making a sacrificial portion (104) on a substrate (102);
- making a cover (106) covering the sacrificial portion (104);
- making at least one hole (108) through the cover (106);
- making a first layer (110) on the cover (106) such that, in a first configuration, the first layer (110) covers at least a first region of the cover (106) located around the hole (108), or in a second configuration, the first layer (110) surrounds the first region of the cover (106);
- depositing at least one second layer (112) covering the cover (106) and the first layer (110) and such that in first configuration, an adhesion force between the first and the second layers (110, 112) is less than an adhesion force between the second layer (112) and a second region of the cover (106) adjacent to the first region of the cover (106) or, in the second configuration, an adhesion force between the second layer (112) and the first region of the cover (106) is less than an adhesion force between the first and second layers (110, 112);
- etching the second layer (112) such that a remaining portion of the second layer (112) forms at least one flap (114), of which a first part (116) located facing the hole (108) and the first region of the cover (106) does not hermetically close or seal the hole (108), and of which a second part (118) is fixed to the second region of the cover (106);
- etching the sacrificial portion (104) through the hole (108), forming the cavity (122) between the cover (106) and the substrate (102);
- closing the cavity (122) by a deposition of a plugging material (124) at least on the first part (116) of the flap (114) and at least a part of the cover (106) around the first region of the cover (106).

2. Method according to claim 1, in which in the first configuration the flap (114) adheres to the second region of the cover (106) and does not adhere to the first layer (110) or, in the second configuration, the flap (114) adheres to the first layer (110) and does not adhere to the first region of the cover (106).

3. Method according to one of previous claims, in which in the first configuration, the adhesion force between the first and second layers (110, 112) is less than about 2 N/mm², or in the second configuration, the adhesion force between the second layer (112) and the first region of the cover (106) is less than about 2 N/mm².

4. Method according to one of previous claims, in which in the first configuration, part of the first layer (110) is located in the hole (108), and in which etching of the sacrificial portion (104) is preceded by etching at least part of the first layer (110) located in the hole (108).

5. Method according to one of previous claims, in which in the first configuration, the adhesion force between the second layer (112) and the second region of the cover (106) is greater than or equal to about 20 N/mm² or, in the second configuration, the adhesion force between the first and second layers (110, 112) is greater than or equal to about 20 N/mm².

6. Method according to one of previous claims, in which in the first configuration, the first layer (110) comprises at least one polymer, or in the second configuration, the first layer (110) comprises at least one metal.

7. Method according to one of previous claims, in which the second layer (112) has a residual stress generating a deformation in the first part (116) of the flap (114) after the second layer (112) has been etched, creating a space between the first part (116) of the flap (114) and the first region of the cover (106) and such that the first part (116) of the flap (114) remains facing the hole.

8. Method according to one of claims 1 to 6, in which the second layer (112) comprises at least distinct first and second materials (126, 128), superposed such that the first material (126) is located between the second material (128) and the cover (106), and with residual stresses with different values or different types, or with different values and different types, creating a deformation of the first part (116) of the flap (114) creating a space between the first part (116) of the flap (114) and the first region of the cover (106), after etching of the second layer (112).

9. Method according to claim 8, also comprising an etching step of at least part of the second material (128), between etching of the sacrificial portion (104) and closing of the cavity (122).

10. Method according to one of claims 8 or 9, in which there is a residual stress in the first material (126) and/or the second material (128).

11. Method according to claim 10, in which the residual stress is either a compressive or a tensile stress.

12. Method according to one of claims 8 to 11, in which the first material (126) contains SiO₂ and the second material (128) contains nickel.

13. Method according to one of claims 8 to 12, in which the second material (128) comprises a stack of titanium and nickel such that titanium is arranged between the first material (126) and the nickel.

14. Method according to one of previous claims, in which the second layer (112) comprises at least first and second distinct materials (126, 128) superposed such that the first material (126) is located between the second material (128) and the cover (106), the first material (126) having a higher coefficient of thermal expansion than that of the second material (128), and in which etching of the sacrificial portion (104) is done at a temperature leading to a deformation of the first part (116) of the flap (114) due to thermal expansion of the first and second materials (126, 128), creating a space between the first part (116) of the flap (114) and the first region of the cover (106).

15. Method according to claim 14, in which the first material (126) comprises aluminium and the second material (128) comprises titanium.

16. Method according to one of claims 14 or 15, in which the plugging material (124) is deposited at ambient temperature.

17. Method according to one of previous claims, in which the second layer (112) comprises at least one getter material.

18. Method according to one of previous claims, in which several holes (108) are made through the cover (106), and :
- the first part (116) of the flap (114) is located facing at least two of said holes (108), and/or
- etching of the second layer (112) forms several flaps (114) such that the first part (116) of each of the flaps (114) is located facing at least one of said holes (108).

19. Method according to one of previous claims, in which the sacrificial portion (104) is made on the substrate (102) such that it covers at least one microelectronic device (100) located on the substrate (102), the microelectronic device (100) being encapsulated in the cavity (122) which is closed after the end of the process.

20. Method according to claim 19, in which the steps performed make collective encapsulation of several microelectronic devices (100) located on the substrate (102).
